(19) Europäisches Patentamt / European Patent Office / Office européen des brevets

(11) **EP 4 546 204 A1**

(12) **EUROPEAN PATENT APPLICATION**
published in accordance with Art. 153(4) EPC


(43) Date of publication:
**30.04.2025 Bulletin 2025/18**

(21) Application number: **23844839.3**

(22) Date of filing: **10.03.2023**

(51) International Patent Classification (IPC):
***G06F 30/367*** *(2020.01)*

(52) Cooperative Patent Classification (CPC):
**G06F 30/367; G06N 3/044; G06N 3/0499; G06N 3/08; H03F 3/213**

(86) International application number:
**PCT/CN2023/080821**

(87) International publication number:
**WO 2024/021621 (01.02.2024 Gazette 2024/05)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(30) Priority: **26.07.2022 CN 202210885045**



(71) Applicant: **ZTE Corporation**
**Shenzhen, Guangdong 518057 (CN)**

(72) Inventor: **YANG, Zhen**
**Shenzhen, Guangdong 518057 (CN)**

(74) Representative: **WBH Wachenhausen Patentanwälte PartG mbB**
**Müllerstraße 40**
**80469 München (DE)**


# (54) METHOD AND APPARATUS FOR ACQUIRING POWER AMPLIFIER MODEL, AND POWER AMPLIFIER MODEL


(57) Embodiments of the present application provide a method and apparatus for acquiring a power amplifier model, a power amplifier model, a storage medium, and a program product. Multiple iterative training is performed on an initial sub-model to obtain a plurality of target sub-models, and a model consisting of the plurality of obtained target sub-models is taken as a final power amplifier model.

S1000
Acquire an initial sub-model, labeled data, and input data of a power amplifier
S2000
Perform, according to the labeled data and the input data, iterative training on the initial sub-model until an iteration stop condition is reached, and after each iterative training is completed, obtain one target sub-model
S3000
Obtain a power amplifier model according to at least one of the target sub-models


FIG. 3




Processed by Luminess, 75001 PARIS (FR)

## Description

### CROSS-REFERENCE TO RELATED APPLICATION

This application is based on and claims the priority of Chinese patent application No. 202210885045.6 filed on July 26, 2022, the disclosure of which is incorporated herein by reference in its entirety.

### TECHNICAL FIELD

Embodiments of the present disclosure relate to the field of signal processing technologies, particularly to a method and apparatus for acquiring a power amplifier model, a power amplifier model, a storage medium, and a program product.

### BACKGROUND

In recent years, with the progress of power amplifier technology, distortion principles of new types of power amplifiers have become increasingly complex. A conventional model, due to its inherent limitation, finds it difficult to accurately depict distortion characteristics of power amplifiers. In a related technology, although the related concept of a power amplifier model based on a neural network has been proposed, there are still many problems in practical application. For example, models have poor generalization abilities, that is, while the models may have high fitting accuracy on a training dataset, the accuracy is often unsatisfactory in practical application. Therefore, how to improve the generalization ability of the power amplifier model based on the neural network is an urgent problem to be solved.

### SUMMARY

Embodiments of the present disclosure provide a method and apparatus for acquiring a power amplifier model, a power amplifier model, a storage medium, and a program product, aiming at improving a generalization ability of a power amplifier model based on a neural network.

In accordance with a first aspect of the present disclosure, an embodiment provides a method for acquiring a power amplifier model, including: acquiring an initial sub-model, labeled data, and input data of a power amplifier; performing, according to the labeled data and the input data, iterative training on the initial sub-model until an iteration stop condition is reached, and after each iterative training is completed, obtaining one target sub-model; and obtaining a power amplifier model according to at least one of the target sub-models.

In accordance with a second aspect of the present disclosure, an embodiment provides an apparatus for acquiring a power amplifier model, including: a memory, a processor, and a computer program stored in the memory and executable by the processor, where the processor, when executing the computer program, implements the method for acquiring a power amplifier model as described in the first aspect.

In accordance with a third aspect of the present disclosure, an embodiment provides a power amplifier model, where the power amplifier model is obtained according to the method for acquiring a power amplifier model as described in the first aspect.

In accordance with a fourth aspect of the present disclosure, an embodiment provides a computer-readable storage medium, storing computer-executable instructions, where the computer-executable instructions are used to perform the method for acquiring a power amplifier model as described in the first aspect.

In accordance with a fifth aspect of the present disclosure, an embodiment provides a computer program product, including a computer program or computer instructions stored in a computer-readable storage medium, from which a processor of a computer device reads the computer program or the computer instructions, where the computer program or the computer instructions, when executed by the processor, cause the computer device to perform the method for acquiring a power amplifier model as described in the first aspect.

According to the method and apparatus for acquiring a power amplifier model, the power amplifier model, the storage medium, and the program product provided by the embodiments of the present disclosure, multiple times of iterative training is performed on an initial sub-model to obtain multiple target sub-models, and a model constituted by the obtained multiple target sub-models is used as a final power amplifier model. By optimizing a model structure and a training process, a generalization ability of the power amplifier model and the prediction accuracy of the model are improved.

### BRIEF DESCRIPTION OF DRAWINGS

FIG. 1 is a diagram of an application environment of a method for modeling a power amplifier according to an embodiment of the present disclosure;

FIG. 2 is a diagram of a principle of modeling a power amplifier according to an embodiment of the present disclosure;

FIG. 3 is a flowchart of a method for acquiring a power amplifier model according to an embodiment of the present disclosure;

FIG. 4 is a flowchart of calculating a priority of historical-time input data according to an embodiment of the present disclosure;

FIG. 5 is a flowchart of calculating a priority of historical-time input data according to another embodiment of the present disclosure;

FIG. 6 is a flowchart of acquiring a pre-trained neural network model according to an embodiment of the present disclosure;

FIG. 7 is a flowchart of selecting a target sub-model to construct a power amplifier model according to an embodiment of the present disclosure;

FIG. 8 is a structural schematic diagram of a power amplifier model according to an example of the present disclosure;

FIG. 9 is a structural schematic diagram of a power amplifier model according to another example of the present disclosure;

FIG. 10 is a structural schematic diagram of a power amplifier model according to another example of the present disclosure;

FIG. 11 is a schematic diagram of a model structure of an initial sub-model according to an example of the present disclosure;

FIG. 12 (a) is a diagram of a model structure of one unit in an example initial sub-model of the present disclosure;

FIG. 12 (b) is a diagram of a model structure of one unit in an example initial sub-model of the present disclosure;

FIG. 12 (c) is a diagram of a model structure of one unit in an example initial sub-model of the present disclosure;

FIG. 12 (d) is a diagram of a model structure of one unit in an example initial sub-model of the present disclosure;

FIG. 13 is a structural diagram of a power amplifier model according to an embodiment of the present disclosure;

FIG. 14 is a structural diagram of a power amplifier model according to an embodiment of the present disclosure; and

FIG. 15 is a structural schematic diagram of an apparatus for acquiring a power amplifier model according to an embodiment of the present disclosure.

## DETAILED DESCRIPTION

In order to make the objectives, technical schemes and advantages of the present disclosure more apparent, the present disclosure is further described in detail in conjunction with the accompanying drawings and embodiments. It should be understood that the particular embodiments described herein are only intended to explain the present disclosure, and are not intended to limit the present disclosure.

It is to be noted that although a functional module division is shown in a schematic diagram of an apparatus and a logical order is shown in a flowchart, the steps shown or described may be executed, in some cases, with a different module division from that of the apparatus or in a different order from that in the flowchart. The terms such as "first" and "second" in the description, claims and above-mentioned drawings are intended to distinguish between similar objects and are not necessarily to describe a specific order or sequence.

In the embodiments of the present disclosure, the term such as "further," "exemplary," or "optionally" is used to represent as an example, an illustration, or a description and should not be construed as being more preferred or advantageous than another embodiment or design. The use of the term such as "further," "exemplary," or "optionally," is intended to present a related concept in a specific manner.

A radio frequency (RF) power amplifier, an important component in a wireless communication system, amplifies a power of a wireless signal to a target value and then feeds the signal into an antenna. The RF power amplifier has two remarkable characteristics: nonlinearity and memory. The nonlinearity is mainly manifested in that a gain of the power amplifier to an input signal changes with an increase of a power of the input signal, and is not constant. Nonlinearity will cause the constellation of the signal to be distorted, especially for an Orthogonal Frequency Division Multiplexing (OFDM) signal with a Peak to Average Power Ratio (PAPR). Memory means that an output of the power amplifier is not only related to an input at a current time, but also related to an input signal at a historical time. An effect of memory is related to a bandwidth of the signal. A larger bandwidth of the signal indicates a greater effect of memory that cannot be ignored.

Behavior modeling of power amplifiers is the basis of research work related to power amplifiers, such as digital pre-distortion (DPD). Power amplifier modeling is to simulate the nonlinearity and memory of the power amplifier to establish a mathematical relationship between the input and output of the power amplifier.

In a related technology, models used for power amplifier modeling can be generally divided into two categories, one of which is conventional models, such as a Memory Polynomial (MP) model and a Generalized Memory Polynomial (GMP) model based on a volterra model; and the other is neural network-based models, such as an RVTDNN model based on an MLP network and an RNN network-based model. In the design of conventional power amplifier models, characteristics of the power amplifier are fully considered. For example, higher-order terms in the model correspond to intermodulation components in products of the power amplifier. Therefore, the model matches well with the actual power amplifier and has a good generalization ability. With the advancement of power amplifier technology, distortion principles of power amplifiers have become complex, and the modeling accuracy of conventional models has dropped significantly. Researchers have begun to turn their attention to methods based on neural networks. Different from the conventional power amplifier model, a neural network is a general model, with power amplifier modeling being merely one of its application scenarios. Because the design of the model does not consider distortion characteristics of the power amplifier, the model based on the neural network generally has the defect of a poor generalization ability, that is, the model has high fitting accuracy on a training set, but the fitting accuracy is greatly attenuated on a test set, especially when a number of samples in the training set is small.

Based on this, embodiments of the present disclosure provide a method and apparatus for acquiring a power amplifier model, a power amplifier model, a storage medium, and a program product. Multiple times of iterative training is performed on an initial sub-model to obtain multiple target sub-models, and a model constituted by the obtained multiple target sub-models is used as a final power amplifier model. By optimizing a model structure and a training process, a generalization ability of the power amplifier model and the prediction accuracy of the model are improved.

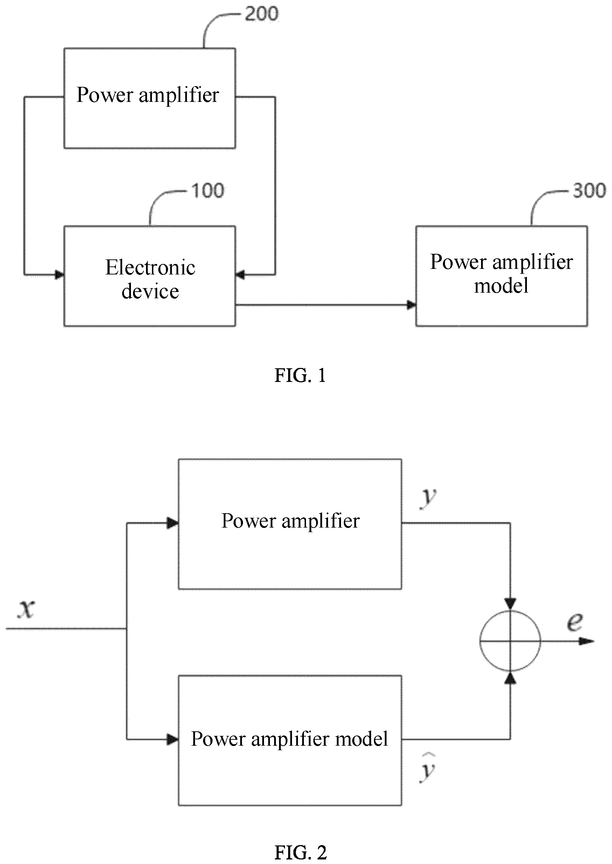

The method for acquiring a power amplifier model provided in the present disclosure can be applied to an application environment described in FIG. 1. An electronic device 100 acquires input and output sample values of a power amplifier 200, and then models input and output characteristics of the power amplifier to obtain a power amplifier model 300. The electronic device may be a predistortion module in a base station or a signal processing unit in a radar system, which is not limited in the embodiment of the present disclosure. The power amplifier may be a power amplifier component in a base station, a power amplifier unit in a radar system, a power amplifier device in a terminal device, or the like, which is not limited in the embodiment of the present disclosure.

FIG. 2 is a diagram of a principle of modeling a power amplifier according to an embodiment of the present disclosure. As shown in the figure, assuming that an input signal and an output signal of the power amplifier are $x$ and $y$, respectively, a principle of modeling the power amplifier is shown in FIG. 2. The goal is to minimize an error $e$ between an output $\hat{y}$ of an established power amplifier model and an output $y$ of the PA.

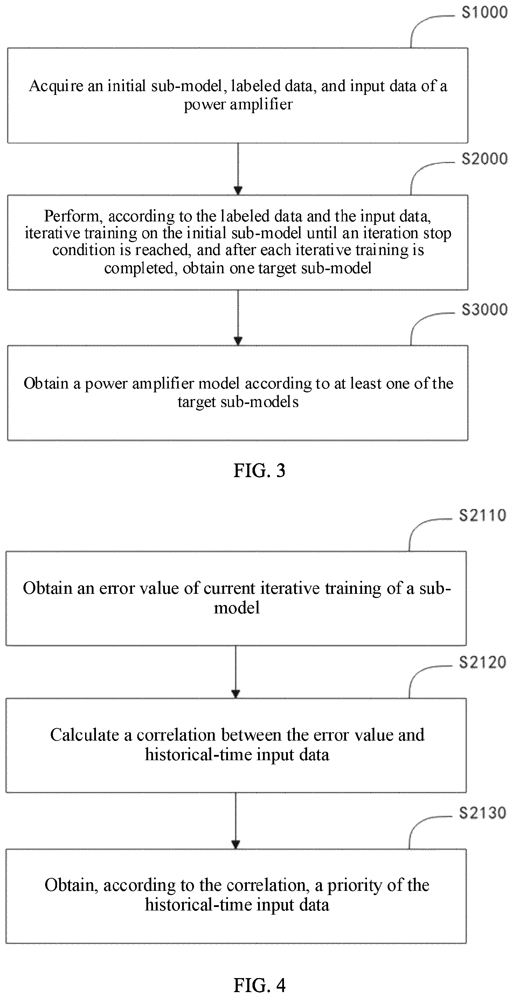

FIG. 3 is a flowchart of a method for acquiring a power amplifier model according to an embodiment of the present disclosure. As shown in FIG. 3, the method for acquiring a power amplifier model may include, but is not limited to, steps S1000, S2000, and S3000.

At S1000, an initial sub-model, labeled data, and input data of a power amplifier are acquired.

In an embodiment, the initial sub-model of the power amplifier is a neural network model, the labeled data is an error between an actual output signal of the power amplifier and an output signal of the initial sub-model of the power amplifier, and the input data is an input signal at a current time and an input signal at a historical time. With consideration of an effect of the input signal at the historical time on an output at the current time, in the embodiment of the present disclosure, during acquisition of input data of the model, the input signal at the historical time is acquired as the input data of model training. In the field of power amplifier technology, memory depth is usually used to indicate how long ago the input signal related to the current output signal came from.

In another embodiment, the initial sub-model of the power amplifier is a model constituted by multiple neural network models, and the initial sub-model constituted by multiple neural network models may have more advantages in data fitting.

It can be understood that the initial sub-model may be one neural network model or a model constituted by multiple neural network models, and different initial sub-models may be selected according to different needs of application scenarios.

At S2000, according to the labeled data and the input data, iterative training is performed on the initial sub-model until an iteration stop condition is reached, and after each iterative training is completed, one target sub-model is obtained.

In an embodiment, the labeled data and the input data are used to perform iterative training on the initial sub-model. When the iteration stop condition is reached, the iterative training is stopped, and one trained target sub-model is obtained. After each iterative training, the labeled data is updated according to an output of the target sub-model to obtain new labeled data, and the new labeled data is used for next iterative training of the sub-model.

In an embodiment, the iteration stop condition is a preset number of iterations. Therefore, in response to a current number of iterations being less than the preset number of iterations, current-time input data and at least one of historical-time input data are input to the initial sub-model for continuous iterative training, and one target sub-model is generated after each iterative training. Multiple target sub-models obtained through multiple times of iterative training are likely to form a final power amplifier model.

In an embodiment, the iteration stop condition is a preset number of iterations. Therefore, in response to a current number of iterations being less than the preset number of iterations, current-time input data and all historical-time input data are input to the initial sub-model for continuous iterative training, and one target sub-model is generated after each iterative training. Multiple target sub-models obtained through multiple times of iterative training are likely to form a final power amplifier model.

In an embodiment, the iteration stop condition is a preset number of iterations. Therefore, in response to a current number of iterations being less than the preset number of iterations, in each iterative training process, current-time input data and a part of historical-time input data are input to the initial sub-model. The iterative training is stopped until the preset number of iterations is reached, and one target sub-model is generated after each iterative training. Multiple target sub-models obtained through multiple times of iterative training are likely to form a final power amplifier model.

In an embodiment, the iteration stop condition is that all historical-time input data are used in the iterative training of the model. Therefore, in a current iterative training process, a priority of each piece of historical-time input data is generated according to a preset priority calculation condition; a set of historical-time input data is constructed according to a current number of times of iterative training of the sub-model and the priorities of the historical-time input data; and in response to input data of current iterative training not reaching the iteration stop condition, the current-time input data and the set of historical-time input data are input to the initial sub-model for iterative training. It should be noted that, to construct the set of historical-time input data, it is necessary to sort the historical-time input data according to the priorities of the historical-time input data, to obtain sorted historical-time input data, and sequentially select, from the sorted historical-time input data, a target number of historical-time input data to construct the set of historical-time input data, where the target number is equal to the current number of times of iterative training of the sub-model. It can be understood that as the number of times of iterative training of the sub-model increases, an increasing amount of historical-time input data are selected to constitute the set of historical-time input data until all the historical-time data are selected to constitute the set of historical-time input data, and then the iterative training of the sub-model is completed. The first iterative training (a $0^{th}$ iteration) of the sub-model only requires data at a current time as an input of training data. Therefore, in this embodiment, assuming memory depth is Q, the iterative training process of the sub-model needs to be performed (Q+1) times, and finally (Q+1) target sub-models are generated.

It can be understood that, in some embodiments, the set of historical-time input data can be constructed in other manners. For example, in each iterative training, two or more high-ranked historical-time input data are selected and added to a set of historical-time input data constructed in the previous iterative training to form a new set of historical-time input data. By this method, a total number of times of iterative training of the sub-model can be reduced, and the efficiency of model training can be improved.

It can be understood that sorting the priorities of the historical-time input data is to find historical-time input data that has the greatest impact on an output of a current model. There are many ways to calculate the priority of the historical-time input data. Several embodiments will be provided below for detailed description.

FIG. 4 is a flowchart of calculating a priority of historical-time input data according to an embodiment of the present disclosure. In this embodiment, calculation of the historical-time input data includes at least steps S2110, S2120, and S2130.

At S2110, an error value of current iterative training of the sub-model is obtained.

In an embodiment, a residual signal in the current iterative training process is calculated, where the residual signal is a difference between an actual output of the power amplifier and an estimated output of the model.

It can be understood that other manners that can represent the difference between the actual output of the power amplifier and the estimated output of the model may also be used to calculate a correlation. This is not limited in this embodiment of the present disclosure.

At S2120, a correlation between the error value and the historical-time input data is calculated.

In an embodiment, a correlation degree between the error value and the historical-time input data is calculated according to a correlation degree calculation formula, and the correlation degree value is obtained.

It can be understood that any method that can calculate the correlation degree between the error value and the historical-time input data can be used in the correlation degree calculation in step S2120 of this embodiment of the present disclosure. This is not limited in this embodiment of the present disclosure.

At S2130, according to the correlation, the priority of the historical-time input data is obtained.

In an embodiment, the obtained correlation degree values are sorted. A larger correlation degree value indicates a higher correlation, greater impact of a corresponding piece of historical-time input data on a current output of the model, and a higher priority of the historical-time input data. By preferentially using the historical-time input data with a higher priority to construct the set of historical-time input data, the generation efficiency and prediction accuracy of the final power amplifier model can be improved.

In the embodiment of FIG. 4, multiple sets of historical-time input data having different historical-time input data are sequentially constructed according to the priorities of the historical-time input data, the sets of historical-time input data are used to perform iterative training on the sub-model, and multiple target sub-models are generated, which can effectively improve the training efficiency of the model and a generalization ability of the model in an actual application scenario.

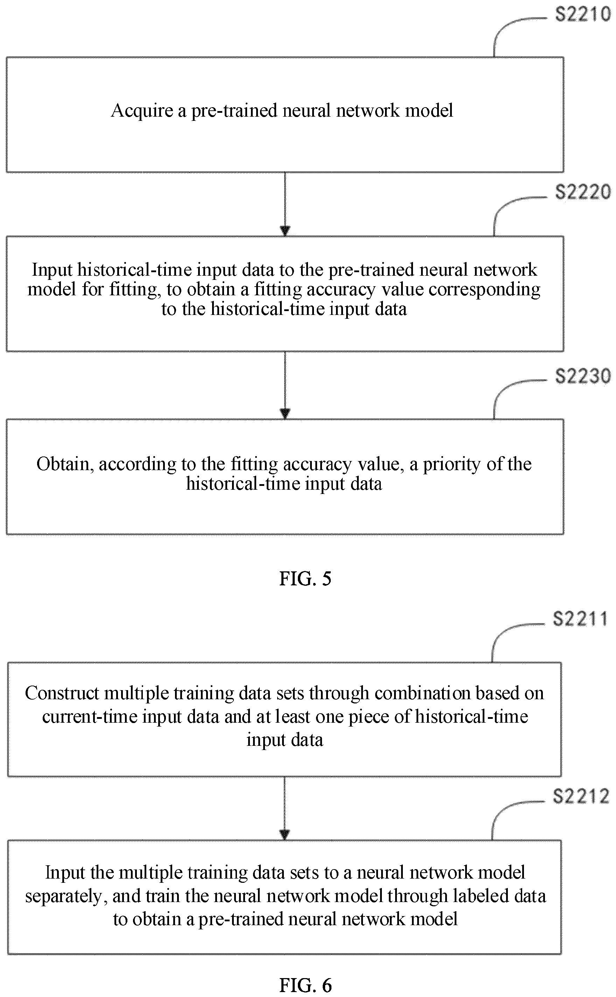

FIG. 5 is a flowchart of calculating a priority of historical-time input data according to another embodiment of the present disclosure. In this embodiment, calculation of the historical-time input data includes at least steps S2210, S2220, and S2230.

At S2210, a pre-trained neural network model is acquired.

In an embodiment, a pre-trained neural network model is obtained as a prediction model for fitting accuracy of historical-time input data. The pre-trained neural network model is a model trained by using training data, and can generate fitting accuracy corresponding to the historical-time input data in actual prediction.

FIG. 6 is a flowchart of acquiring a pre-trained neural network model according to an embodiment of the present disclosure. Acquisition of the pre-trained neural network model includes steps S2211 and S2212.

At S2211, multiple training data sets are constructed through combination based on the current-time input data and at least one piece of the historical-time input data.

In an embodiment, since the model is designed to predict the fitting accuracy of the historical-time input data, during training of the model, the used input data in the training data is a combination of the current-time input data and the historical-time input data, and the labeled data in the training data is an error value between an actual output and an estimated output.

In an embodiment, priorities of the historical-time input data are sorted, and top-ranked historical-time input data are selected to construct the input data together with the current-time input data, where the constructed input data is called a temporary queue. In this embodiment, during constructing the first temporary queue, the temporary queue includes the current-time input data and historical-time input data with a top-ranked priority, during constructing the second temporary queue, the temporary queue includes the current-time input data and two pieces of historical-time input data with highest priorities, and so on, until all the historical-time input data are selected to construct the temporary queues.

It can be understood that this step is about pre-training of the model, and therefore, as many temporary queues as possible can be built to obtain more training data, so that in a training process of the model, a model with more accurate prediction results can be generated. However, in some application scenarios, due to a limitation of a computing power or in order to prevent over-fitting of the model, a part of the historical-time input data can be selected to form the training data with the current input data, where these selected historical-time input data may be randomly selected.

At S2212, the multiple training data sets are input to a neural network model separately, and the neural network model is trained with the labeled data to obtain the pre-trained neural network model.

In an embodiment, after the neural network model is selected, the model can be trained, and training steps are the same as those of a commonly used neural network. Details are not repeated in the present disclosure.

It can be understood that the selection of the neural network model in this step can be adjusted according to an actual need, and a commonly used supervised learning method can also be used for training the neural network model. This is not limited in this embodiment of the present disclosure.

At S2220, the historical-time input data is input to the pre-trained neural network model for fitting, to obtain a fitting accuracy value corresponding to the historical-time input data.

In an embodiment, the historical-time input data is input to the trained neural network model, so that the fitting accuracy value corresponding to the historical-time input data can be estimated.

At S2230, according to the fitting accuracy value, the priority of the historical-time input data is obtained.

In an embodiment, a higher fitting accuracy value indicates a higher priority corresponding to the historical-time input data, while a lower fitting accuracy value indicates a lower priority corresponding to the historical-time input data.

It can be understood that in actual application, when estimated fitting accuracy values exceed a preset threshold value, it is not necessary to sort these historical-time input data having fitting accuracy values exceeding the threshold value, and these historical-time input data having high fitting accuracy have the same status in the set of historical-time input data.

At S3000, a power amplifier model is obtained according to at least one of the target sub-models.

In an embodiment, all the target sub-models generated by iterative training of the sub-model are used to construct the final power amplifier model. The power amplifier model obtained in this way includes effects of all historical-time input data on an output of the model, and therefore may have high prediction accuracy in some application scenarios.

In another embodiment, only a part of the target sub-models obtained by iterative training are selected to construct the final power amplifier model. The reason is that in some application scenarios, although the power amplifier has memory, the actual output is related to only historical inputs at several specific time points. Therefore, a threshold may be set for one or more statistical dimensions, for example, mean squared error (MSE) or normalized mean squared error (NMSE), in the iterative training process of the sub-model. If a statistic of a network sub-model is worse than the threshold after the network sub-model is iteratively trained to converge, it can be considered that this target sub-model is not helpful in constructing the final power amplifier model, and therefore one or more target sub-models that do not meet a threshold requirement are discarded.

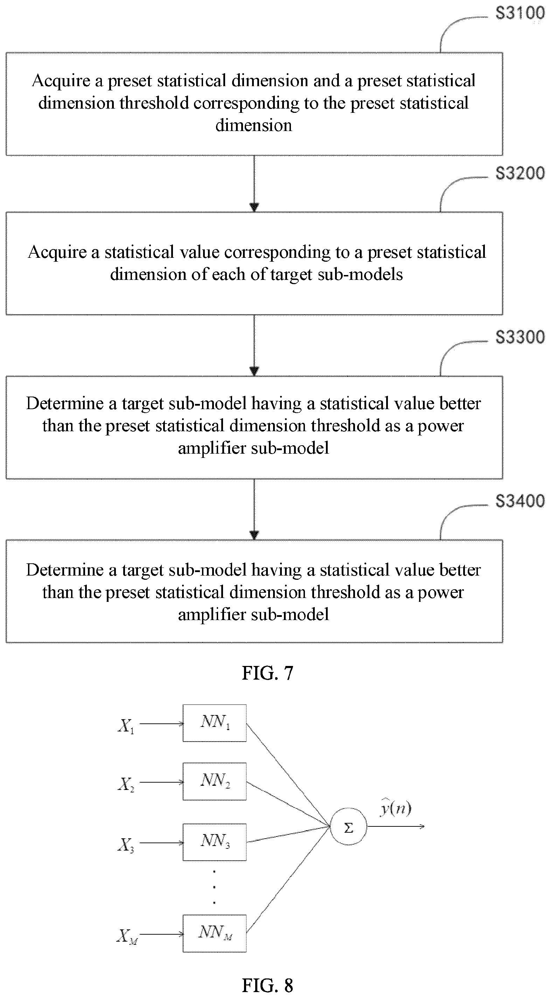

FIG. 7 is a flowchart of selecting a target sub-model to construct a power amplifier model according to an embodiment of the present disclosure. As shown in the figure, at least steps S3100, S3200, S3300, and S3400 are included.

At S3100, a preset statistical dimension and a preset statistical dimension threshold corresponding to the preset statistical dimension are acquired.

In an embodiment, MSE is selected as the statistical dimension, and an MSE threshold is preset in advance. If an MSE of the target sub-model exceeds the preset MSE threshold, it means that a training effect of the sub-model does not meet expectations, and the target sub-model may be discarded subsequently. In this case, other target sub-models having MSEs not exceeding the preset MSE threshold may be selected to construct the final power amplifier model.

At S3200, a statistical value corresponding to the preset statistical dimension of each of the target sub-models is acquired.

In an embodiment, an MSE of each of the target sub-models is acquired.

At S3300, a target sub-model having a statistical value better than the preset statistical dimension threshold is determined as a power amplifier sub-model.

In an embodiment, target sub-models having MSEs less than or equal to the MSE threshold are selected, and these target sub-models meeting a requirement are finally used to construct the power amplifier model.

In another embodiment, MSEs of all the target sub-models are less than or equal to the MSE threshold. However, in order to simplify the model, a preset number of target sub-models having smaller MSEs may be selected to construct the power amplifier model.

In another embodiment, a manner of constructing the final power amplifier model using a part of the target sub-models may also be used. However, different from the previous embodiment in which models are screened by presetting a threshold for the statistical dimension, in this embodiment, the complexity of the final power amplifier model is directly preset, and according to the set complexity, convergence degrees of the target sub-models are sorted, and one or more target sub-models are discarded, so that a power amplifier model constituted by the remaining target sub-models meet the preset model complexity.

It can be understood that the embodiments of the present disclosure may have other manners of selecting the target sub-model, and are not limited to the manners provided in the above-described embodiments.

At S3400, a target sub-model having a statistical value better than the preset statistical dimension threshold is determined as a power amplifier sub-model.

In an embodiment, according to statistical values of MSEs, the power amplifier sub-models are sorted to obtain a sorting order, and a model constituted by the power amplifier sub-models in the sorting order is determined as the power amplifier model.

Therefore, the embodiment in which only a part of the target sub-models is used to construct the final power amplifier model can reduce a number of sub-models used for the model, thereby reducing parameters of the model, reducing the complexity of the model, and improving a generalization ability of the model.

An application process of the method for acquiring a power amplifier model provided by the embodiments of the present disclosure will be described in detail below through five examples.

Example I:

Memory depth of a power amplifier model is set to $Q$, and then an input of the power amplifier model is $x(n)$, $x(n-1)$, ..., and $x(n-Q)$, where $x(n)$ represents current-time input data, and the rest are memory items, that is, historical-time input data; an iteration counter is initialized as iter = 1; and a model output is initialized as $\hat{y} = 0$ .

At S101, an initial sub-model is acquired, that is, the sub-model is initialized as $NN_{iter}$.

At S102, input data $X_{iter}$ and labeled data $Y_{iter}$ of the initial sub-model $NN_{iter}$ are generated, where the input data $X_{iter}$ and the labeled data $Y_{iter}$ are generated as follows:

$$X_{iter} = \begin{bmatrix} x(n-\tau_1) \\ \vdots \\ x(n-\tau_i) \\ \vdots \\ x(n-\tau_N) \end{bmatrix}, \text{ and } Y_{iter} = y(n) - \hat{y}(n),$$

where $N \geq 1$, and $\tau_i \in \{0,1,..., Q\}$.

A training process is described in more detail below.

For example, in the first iteration process, the current-time input data $x(n)$ is used for training; in the second iteration process, the current-time input data x(n) and the historical-time input data $x(n-1)$ with memory depth of 1 are used for training; in the third iteration process, the current-time input data $x(n)$, the historical-time input data $x(n-1)$ with memory depth of 1, and historical-time input data $x(n-2)$ with memory depth of 2 are used for training; and so on.

At S103, the initial sub-model is trained to converge.

At S104, according to a generated target sub-model, an output of the power amplifier model is updated to $\hat{y} = \hat{y} + NN_{iter}(X_{iter})$.

At S105, it is determined whether an iterative training stop condition is met; and if it is met, the iteration is stopped, or if it is not met, the iteration counter is updated, that is, iter = iter + 1, and the process returns to step S101. In this example, the iterative training stop condition is that a preset number threshold M of iterations is reached.

After iterative training is performed M times, the iteration is stopped. After the algorithm flow is completed, M target sub-models $NN_1$, $NN_2$, ..., and $NN_M$ are obtained. These M target sub-models jointly constitute the power amplifier model proposed in the example of the present disclosure. A principle diagram of the model is shown in FIG. 8.

Example II:

Memory depth of a power amplifier model is set to $Q$ ; queue $S_1 = \{0\}$ and queue $S_2 = \{1,2,..., Q\}$ are obtained through initialization; an iteration counter is initialized as iter = 1; and a model output is initialized as $\hat{y} = 0$.

Example II is similar to Example I in that the same initial sub-model is used, with a difference that a sub-model training method in Example II is different. Details are provided as follows:

At S201, an initial sub-model is acquired, that is, the sub-model is initialized as $NN_{iter}$.

At S202, input data X and labeled data Y of a sub-model neural network $NN_{iter}$ are generated, where X and Y are generated as follows:

$$X = \begin{bmatrix} x(n - S_1^1) \\ x(n - S_1^2) \\ \vdots \\ x(n - S_1^{iter}) \end{bmatrix}, \text{ and } Y = y(n) - \hat{y}(n),$$

where $S_1^i$ represents an ith element in the queue $S_1$.

At S203, the sub-model neural network $NN_{iter}$ is trained to converge.

At S204, according to a generated target sub-model, an output of the power amplifier model is updated to $\hat{y} = \hat{y} + NN_{iter}(X)$.

At S205, it is determined whether the queue $S_2$ is empty, and if it is empty, the process ends.

It should be noted that in the first iterative training, only current-time input data is used for model training, and therefore, the queue $S_2$ is certainly not empty.

At S206, a priority order of elements within the queue $S_2$ is calculated.

In an example, a correlation measurement method is used to calculate a priority of historical-time input data in the queue $S_2$. A specific calculation process is as follows:

At sub-step 1, a residual signal $r$ of a current iteration is calculated, where $r = y - \hat{y}$.

At sub-step 2, a relevant metric $corr(S_2^i)$ of an $i^{th}$ element $S_2^i$ in the queue $S_2$ is calculated, where $corr(S_2^i)=\sum_n\left|r(n)\cdot conj\left(x\left(n-S_2^i\right)\right)\right|$.

At sub-step 3, prioritization is performed according to correlation metrics, and a larger correlation metric indicates a higher priority.

It can be understood that the calculation complexity of priority calculation by using the correlation measurement method is low, priority values can be generated quickly, and then the priority order can be obtained.

At S207, an element with the highest priority in the queue $S_2$ is added to the end of the queue $S_1$ and is removed from the queue $S_2$.

It should be noted that each time one piece of historical-time input data in the queue $S_2$ is added to the queue $S_1$, a number of elements in the queue $S_2$ gradually decreases until the queue $S_2$ is empty, while a number of elements in the queue $S_1$ gradually increases. In other words, an amount of input data used for iterative training of the sub-model gradually increases. This means that training using only the current-time input data changes to a training process with an increasing quantity of historical-time input data involved.

It can be understood that, in this example, one piece of historical-time input data is added to the current-time input data at a time and constitutes input data of current iterative training, while in other examples, if memory depth is quite large, two or more historical-time input data can be added to the current-time input data at a time, thereby saving a time of model training and improving the efficiency of model training.

At S208, the iteration counter is updated, that is, iter = iter + 1, and the process returns to step S201.

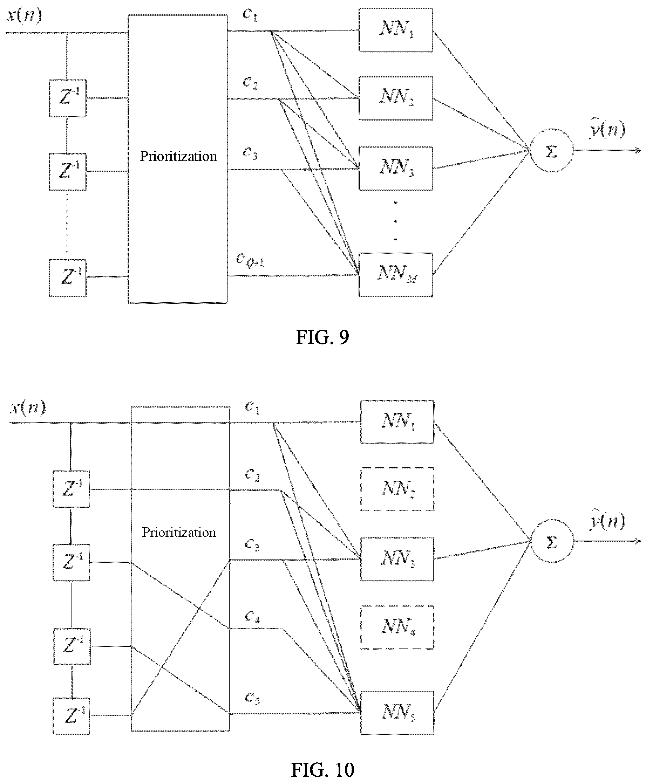

After iterative training is performed (Q+1) times, the iteration is stopped. After the algorithm flow is completed, (Q+1) target sub-models $NN_1$, $NN_2$, ..., and $NN_{Q+1}$ are obtained. These (Q+1) target sub-models jointly constitute the power amplifier model proposed in the example of the present disclosure. A principle diagram of the model is shown in FIG. 9.

A priority sorting module in the figure sorts $x(n)$, $x(n - 1)$, ..., and $x(n - Q)$ according to an order of elements in the queue $S_1$ for output, that is, $c_1 = x\left(n - S_1^1\right),\ c_2 = x\left(n - S_1^2\right),\ ...$, and $c_{Q+1} = x\left(n-S_1^{Q+1}\right)$.

Example III:

Memory depth of a power amplifier model is set to $Q$ ; queue $S_1$ = {0} and queue $S_2$ = {1,2,..., $Q$} are obtained through initialization; an iteration counter is initialized as iter = 1; and a model output is initialized as $\hat{y} = 0$ .

Example III is similar to Example II in that the same initial sub-model and training concepts are used, with a difference that a priority calculation method of historical-time input data in Example III is different. Details are provided as follows:

At S301, an initial sub-model is acquired, that is, the sub-model is initialized as $NN_{iter}$

At S302, input data X and labeled data Y of a sub-model neural network $NN_{iter}$ are generated, where X and Y are generated as follows:

$$X = \begin{bmatrix} x\left(n - S_1^1\right) \\ x\left(n - S_1^2\right) \\ \vdots \\ x\left(n - S_1^{iter}\right) \end{bmatrix}, \text{ and } \ Y = y(n) - \hat{y}(n),$$

where $S_1^i$ represents an $i^{th}$ element in the queue $S_1$.

At S303, the sub-model neural network $NN_{iter}$ is trained to converge.

At S304, according to a generated target sub-model, an output of the power amplifier model is updated to $\hat{y} = \hat{y} + NN_{iter}(X)$.

At S305, it is determined whether the queue $S_2$ is empty, and if it is empty, the process ends.

It should be noted that in the first iterative training, only current-time input data is used for model training, and therefore, the queue $S_2$ is certainly not empty.

At S306, a priority order of elements within the queue $S_2$ is calculated.

In an example, a correlation measurement method is used to calculate a priority of historical-time input data in the

queue $S_2$. A specific calculation process is as follows:

At sub-step 1, a temporary queue Ω is generated, where $\Omega = \{S_1, S_2^i\}$, and $S_2^i$ represents an $i^{th}$ element in the queue $S_2$.

At sub-step 2, a neural network $NN_{tmp}$ is initialized.

It should be noted that the neural network $NN_{tmp}$ may be any type of neural network meeting a requirement.

At sub-step 3, input data X and labeled data Y of the neural network $NN_{tmp}$ are generated, where X and Y are generated as follows:

$$X = \begin{bmatrix} x(n-\Omega^1) \\ x(n-\Omega^2) \\ \vdots \\ x(n-\Omega^{iter}) \\ x(n-\Omega^{iter+1}) \end{bmatrix}, \text{and } Y = y(n) - \hat{y}(n),$$

where $\Omega^i$ represents an $i^{th}$ element in the queue Ω.

It should be noted that the purpose of generating the temporary queue is to train the neural network $NN_{tmp}$, so that the trained model $NN_{tmp}$ can accurately predict the fitting accuracy of historical-time input data in an application process, so as to know which historical-time input data have greater effects on an output result, and then give them higher priorities.

At sub-step 4, the neural network $NN_{tmp}$ is trained using the above input data and labeled data.

At sub-step 5, fitting accuracy $\phi(S_2^i)$ of $NN_{tmp}$ is calculated.

It should be noted that after the model is trained, a pre-trained neural network model is obtained. The historical-time input data is input into the pre-trained neural network model, which predicts fitting accuracy of the input data.

At sub-step 6, prioritization is performed according to the fitting accuracy, and higher fitting accuracy indicates a higher priority.

At S307, an element with the highest priority in the queue $S_2$ is added to the end of the queue $S_1$ and is removed from the queue $S_2$.

It should be noted that each time one piece of historical-time input data in the queue $S_2$ is added to the queue $S_1$, a number of elements in the queue $S_2$ gradually decreases until the queue $S_2$ is empty, while a number of elements in the queue $S_1$ gradually increases. In other words, an amount of input data used for iterative training of the sub-model gradually increases. This means that training using only the current-time input data changes to a training process with an increasing quantity of historical-time input data involved.

It can be understood that, in this example, one piece of historical-time input data is added to the current-time input data at a time and constitutes input data of current iterative training, while in other examples, if memory depth is quite large, two or more historical-time input data can be added to the current-time input data at a time, thereby saving a time of model training and improving the efficiency of model training.

At S308, the iteration counter is updated, that is, iter = iter + 1, and the process returns to step S301.

After iterative training is performed (Q+1) times, the iteration is stopped. After the algorithm flow is completed, (Q+1) target sub-models $NN_1$, $NN_2$, ..., and $NN_{Q+1}$ are obtained. These (Q+1) target sub-models jointly constitute the power amplifier model proposed in the example of the present disclosure. A principle diagram of the model is shown in FIG. 9.

A priority sorting module in the figure sorts $x(n)$, $x(n - 1)$, ..., and $x(n - Q)$ according to an order of elements in the queue $S_1$ for output, that is, $c_1 = x(n - S_1^1),\ c_2 = x(n - S_1^2), \ldots$, and $c_{Q+1} = x(n - S_1^{Q+1})$.

Example IV:

In some cases, the complexity of a model needs to be simplified to be adaptive to more application scenarios. Therefore, multiple target sub-models obtained in the foregoing Examples I, II, and III may not all be selected for constructing a final power amplifier model. In this case, it is necessary to screen these target sub-models.

A specific method is to set a threshold for a specific statistical dimension in training of a neural network $NN_{iter}$, and this statistical dimension may be MSE or NMSE. If a statistic of the network $NN_{iter}$ is worse than the threshold after the network is trained to converge, it can be considered that $NN_{iter}$ is not helpful for constructing Y, and thus $NN_{iter}$ is

unnecessary and $NN_{iter}$ does not participate in the construction of the final power amplifier model.

In Example IV, the initial sub-model selected in Example I can still be used, but a difference is that the target sub-models are screened in a training process. Details are provided as follows:

Memory depth of a power amplifier model is set to $Q$ ; a statistic threshold is set to $\varphi$; queue $S_1 = \{0\}$ and queue $S_2 = \{1,2,..., Q\}$ are obtained through initialization; an iteration counter is initialized as iter = 1; and a model output is initialized as $\hat{y} = 0$.

At S401, a neural network $NN_{iter}$ is initialized.

At S402, input data X and labeled data Y of the neural network $NN_{iter}$ are generated, where X and Y are generated as follows:

$$X = \begin{bmatrix} x(n - S_1^1) \\ x(n - S_1^2) \\ \vdots \\ x(n - S_1^{iter}) \end{bmatrix}, \text{ and } Y = y(n) - \hat{y}(n).$$

At S403, the neural network $NN_{iter}$ is trained to converge.

At S404, a relationship between a statistic of $NN_{iter}$ and the threshold $\varphi$ is determined; and if the statistic is better than the set threshold, it is considered that $NN_{iter}$ is effective, and an output of the power amplifier model is updated to $\hat{y} = \hat{y} + NN_{iter}(X)$; or if the statistic is worse than the set threshold, it is considered that $NN_{iter}$ is ineffective and $NN_{iter}$ does not participate in the construction of the final power amplifier model.

At S405, it is determined whether the queue $S_2$ is empty, and if it is empty, the process ends.

At S406, a priority order of elements within the queue $S_2$ is calculated.

At S407, an element with the highest priority in the queue $S_2$ is added to the end of the queue $S_1$ and is removed from the queue $S_2$ .

At S408, the iteration counter is updated, that is, iter = iter + 1, and the process returns to step S401.

It is assumed that in one time of power amplifier modeling, the memory depth Q is set to 4, and a target statistic is NMSE. A calculation formula of NMSE is $NMSE = \frac{\sum_n |y(n) - \hat{y}(n)|^2}{\sum_n |y(n)|^2}$.

After the training is completed, elements of the queue $S_1$ are {0,1,4,2,3}. Statistical indexes NMSEs of $NN_2$ and $NN_4$ after the training are higher than the set threshold, and thus $NN_2$ and $NN_4$ are considered as ineffective and do not participate in the construction of the final power amplifier model. The final power amplifier model is shown in FIG. 10.

In this way, this example can reduce a number of target sub-models used for the model, thereby reducing parameters of the model and reducing the complexity of the model.

Example V:

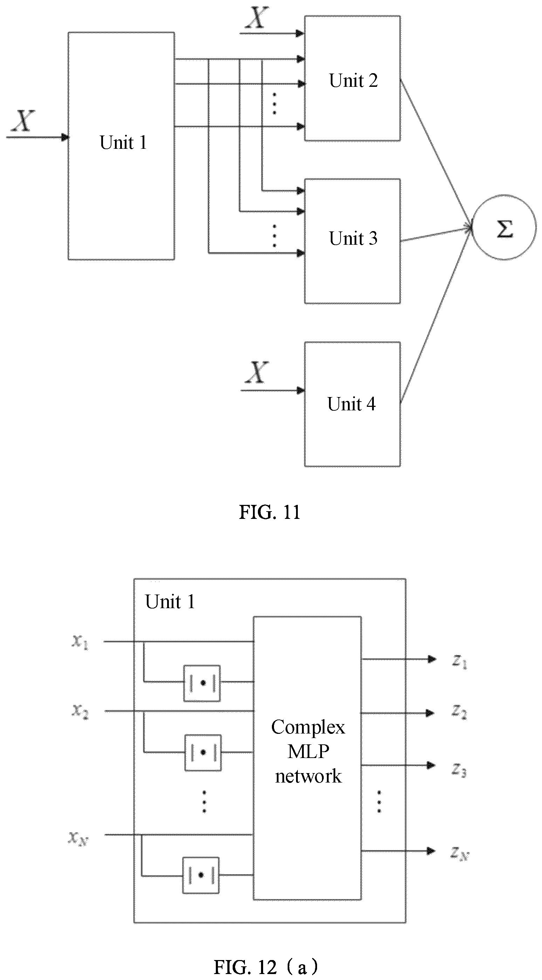

In this example, there is provided a model structure of an initial sub-model $NN_{iter}$. FIG. 11 is a schematic diagram of a model structure of an initial sub-model according to an example of the present disclosure.

As shown in the figure, a main structure of unit 1 is a complex Multilayer Perceptron (MLP) network, and absolute values of an output and an input of unit 1 constitute an input of the MLP network. Unit 2 multiplies each output of unit 1 and X and adds up resultant products. Unit 3 performs weighted summation of the outputs of unit 1, where weight coefficients $w_1$, $w_2$,..., $w_{iter}$ are parameters of the network and are obtained through training. Unit 4 is a linear model, which essentially performs weighted summation on X, where weight coefficients $\theta_1$, $\theta_2$,..., $\theta_{iter}$ are parameters and are obtained through training. Here, $X = [x(n - S_1^1) \quad x(n - S_1^2) \quad \cdots \quad x(n - S_1^{iter})]^T$.

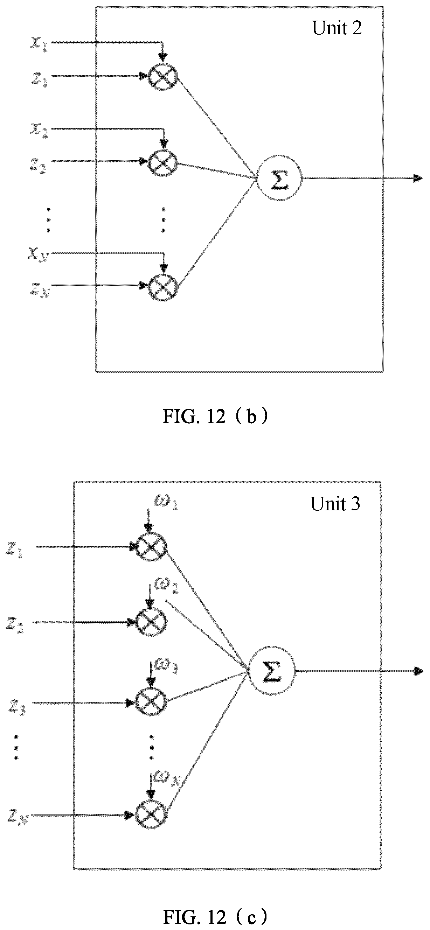

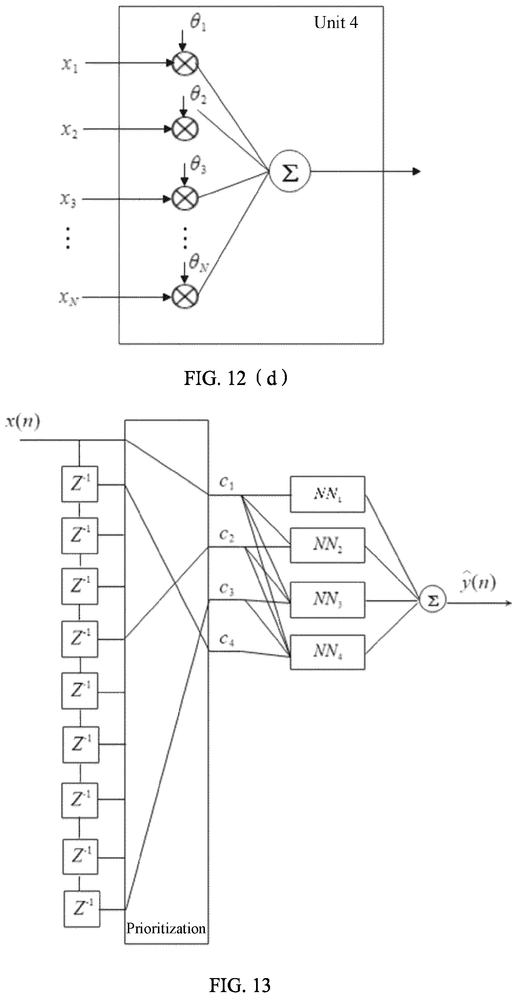

To further explain specific model structures of the units in the initial sub-model, FIGS. 12 (a)-(d) are provided, which are diagrams of model structures of the units in the example initial sub-model of the present disclosure.

It should be noted that the initial sub-model structure provided in this example is merely an example, and those having ordinary skill in the art can select an appropriate initial sub-model structure for training according to actual needs.

According to the method for acquiring a power amplifier model provided in the example of the present disclosure, by optimizing a model structure and a training process, a generalization ability of the power amplifier model and the prediction accuracy of the model are improved.

In an embodiment, a final power amplifier model is obtained according to the method for acquiring a power amplifier model provided by the embodiment of the present disclosure.

The performance of the final power amplifier model obtained according to the method for acquiring a power amplifier model provided by the embodiment of the present disclosure is verified below, and a verification process is as follows:

At S501, a group of input and output data *x* and *y* are acquired from a power amplifier.

At S502, a power amplifier model is extracted from the group of data by separately using a conventional neural network-based power amplifier modeling method and a power amplifier modeling method in the embodiment of the present disclosure.

At S503, a digital predistortion (DPD) model is calculated from the power amplifier model obtained in step S502.

At S504, a signal *z* is obtained based on *x* through the DPD model obtained in step S503, and then a signal $\hat{x}$ is obtained based on the signal z through the power amplifier.

At S505, a DPD performance statistic $P = 10\log_{10}\left(\frac{|\hat{x}/G - x|^2}{|x|^2}\right)$ is calculated by using *x* and $\hat{x}$, where G is a gain of the power amplifier.

The two power amplifier modeling methods may be compared against each other based on their respective statistics P obtained. A smaller P indicates a stronger likeness of the power amplifier model to the real power amplifier.

Both the conventional neural network-based power amplifier modeling method and the power amplifier modeling method proposed in the embodiment of the present disclosure use the neural network model in Example V, and a difference is that a conventional model includes only one neural network, and a number of inputs is (Q+1), while the power amplifier model proposed in the present disclosure includes (Q+1) neural network sub-models, and numbers of inputs are 1, 2, ..., Q+1, respectively. A memory depth Q of the power amplifier model in this embodiment is set to 9.

First, the conventional neural network-based power amplifier modeling method is used to test signals of 20 M and 40 M bandwidths separately. According to an actual test method of this embodiment, final statistics are shown in Table 1 below.

Table 1

| | 20 M bandwidth | 40 M bandwidth |
|---|---|---|
| PA fitting accuracy (dB) | -46.0137 | -41.0371 |
| DPD Performance (dB) | -35.5238 | -28.3481 |

Then, the power amplifier modeling method proposed in the embodiment of the present disclosure is used to test signals of 20 M and 40 M bandwidths separately. In the actual test method of this embodiment, a statistical threshold is set to -1 dB according to Example IV, and final statistics are shown in Table 2 below.

Table 2

| | 20 M bandwidth | | | | 40 M bandwidth | | | |
|---|---|---|---|---|---|---|---|---|
| PA fitting accuracy (dB) | iter=1 | -25.4572 | iter=6 | -46.8054 | iter=1 | -21.3334 | iter=6 | -41.0445 |
| | iter=2 | -36.6185 | iter=7 | -46.8054 | iter=2 | -29.4299 | iter=7 | -41.0445 |
| | iter=3 | -44.4621 | iter=8 | -46.8054 | iter=3 | -36.3138 | iter=8 | -41.0445 |
| | iter=4 | -46.8054 | iter=9 | -46.8054 | iter=4 | -39.3726 | iter=9 | -41.0445 |
| | iter=5 | -46.8054 | iter=10 | -46.8054 | iter=5 | -41.0445 | iter=10 | -41.0445 |
| DPD Performance (dB) | -38.3331 | | | | -36.1032 | | | |

Under the bandwidth of 20 M, neural networks after four iterations of model training cannot meet the threshold requirement, which are not helpful in constructing the power amplifier model. After the training is completed, the queue $S_1$ = {0, 5, 9, 1, 3, 6, 2, 8, 4, 7}, and a final power amplifier model is shown in FIG. 13.

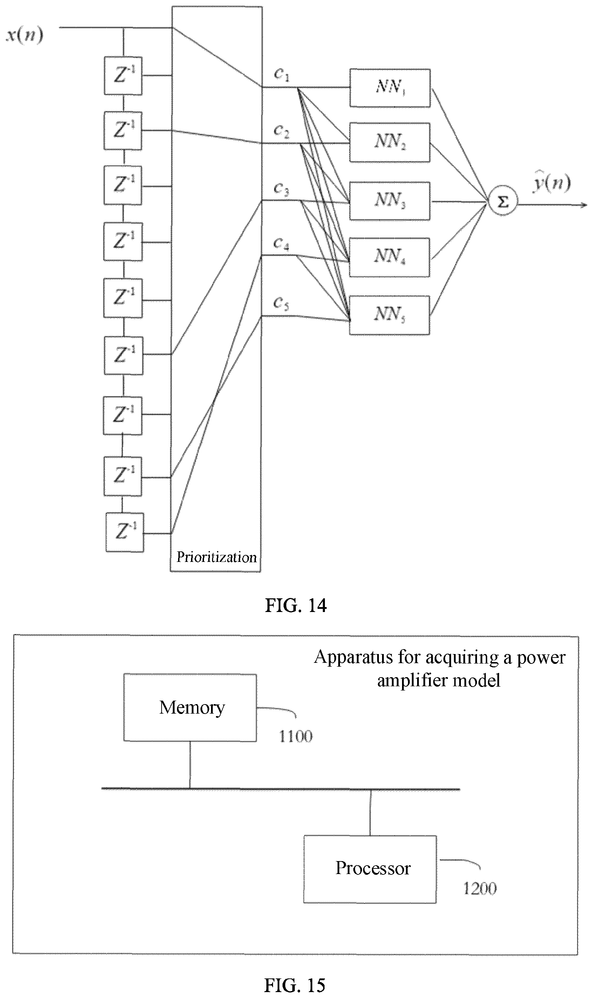

Under the bandwidth of 40 M, neural networks after five iterations of model training cannot meet the threshold requirement, which are not helpful in constructing the power amplifier model. After the training is completed, the queue $S_1$ = {0, 2, 6, 9, 8, 4, 5, 7, 3}, and a final power amplifier model is shown in FIG. 14.

It can be learned from comparison of the two power amplifier modeling methods that, a difference in fitting accuracy of power amplifiers in the two methods is quite small, but a difference is huge when the model is actually used in a digital predistortion DPD test. The performance of the power amplifier modeling method proposed in the embodiment of the present disclosure is obviously better, which indicates that a PA model established by the modeling method proposed in the embodiment of the present disclosure is closer to an actual power amplifier and has better generalization ability.

FIG. 15 is a schematic diagram of an apparatus for acquiring a power amplifier model according to an embodiment of the present disclosure. As shown in FIG. 15, the device includes a memory 1100 and a processor 1200. There may be one or more memories 1100 and processors 1200, although one memory 1100 and one processor 1200 are shown as an example in FIG. 15. The memory 1100 and the processor 1200 of the device may be connected by a bus or in other ways. In FIG. 15, the connection is realized by a bus, for example.

As a computer-readable storage medium, the memory 1100 may be configured to store a software program, a computer-executable program and a module, for example, the program instructions/modules corresponding to the resource determination method of any one of the embodiments of the present disclosure. The processor 1200 implements the above method for acquiring a power amplifier model by running the software programs, instructions and modules stored in the memory 1100.

The memory 1100 may mainly include a program storage area and a data storage area, where the program storage area may store an operating system and application program(s) required by at least one feature. In addition, the memory 1100 may include a high-speed random-access memory and a non-volatile memory, for example, at least one magnetic disk storage device, a flash memory device, or another non-volatile solid-state storage device. In some examples, the memory 1100 may further include memories remotely located with respect to the processor 1200, and these remote memories may be connected to the device via a network. Examples of the above-mentioned network include, but are not limited to, the Internet, an intranet, a local area network, a mobile communication network, and a combination thereof.

A further embodiment of the present disclosure provides a computer-readable storage medium storing computer-executable instructions for executing a method for acquiring a power amplifier model as provided in any embodiment of the present disclosure.

A further embodiment of the present disclosure provides a computer program product, including a computer program or computer instructions stored in a computer-readable storage medium, from which a processor of a computer device reads the computer program or the computer instructions, where the computer program or the computer instructions, when executed by the processor, cause the computer device to perform the method for acquiring a power amplifier model according to any of the embodiments of the present disclosure.

The system architecture and an application scenario described in the embodiment of the present disclosure are for more clearly describing the technical schemes of the embodiments of the present disclosure, and do not constitute a limitation on the technical schemes provided by the embodiments of the present disclosure. Those of ordinary skill in the art may understand that, with evolution of the system architecture and emergence of new application scenarios, the technical schemes provided by the embodiments of the present disclosure are also applicable to similar technical problems.

It can be understood by those of ordinary skill in the art that all or some of the steps of the methods, systems and functional modules/units in the devices disclosed above can be implemented as software, firmware, hardware and appropriate combinations thereof.

In a hardware implementation, the division into functional modules/units mentioned in the above description does not necessarily correspond to the division of physical components; for example, a physical component may have multiple functions, or a function or step may be performed cooperatively by several physical components. Some or all of the physical components may be implemented as software executed by a processor, such as a central processing unit, a digital signal processor or a microprocessor, or as hardware, or as an integrated circuit, such as an application-specific integrated circuit. Such software may be distributed on computer-readable media, which may include computer-readable storage media (or non-transitory media) and communication media (or transitory media). As well known to those of ordinary skill in the art, the term computer-readable storage medium includes volatile and nonvolatile, removable and non-removable media implemented in any method or technique for storing information, such as computer-readable instructions, data structures, program modules or other data. A computer-readable storage medium includes but is not limited to a random access memory (RAM), a read-only memory (ROM), an electrically erasable programmable read-only memory (EEPROM), a flash memory or other memory techniques, a compact disc read-only memory (CD-ROM), a digital versatile disk (DVD) or other optical disk storage, a magnetic cassette, a magnetic tape, magnetic disk storage or other magnetic storage devices, or any other medium that can be used to store desired information and can be accessed by a computer. Furthermore, it is well known to those of ordinary skill in the art that communication media typically contain computer-readable instructions, data structures, program modules or other data in a modulated data signal such as a carrier wave or other transmission mechanism, and may include any information transmission media.

Terms such as "component", "module", and "system" used in this specification indicate computer-related entities, hardware, firmware, combinations of hardware and software, software, or software being executed. For example, a component may be, but is not limited to, a process that runs on a processor, a processor, an object, an executable file, a thread of execution, a program, or a computer. As illustrated by using figures, both a computing device and an application that runs on a computing device may be components. One or more components may reside within a process or a thread of execution, and a component may be located on one computer or distributed between two or more computers. In addition, these components may be executed by various computer-readable media that store various data structures. For example, the components may communicate by using a local or remote process and based on a signal having one or more data packets (for example, data from two components interacting with another component in a local system, a distributed system, or across a network such as Internet interacting with another system by using the signal).

## Claims

**1.** A method for acquiring a power amplifier model, comprising:

acquiring an initial sub-model, labeled data, and input data of a power amplifier;
performing, according to the labeled data and the input data, iterative training on the initial sub-model until an iteration stop condition is reached, and after each iterative training is completed, obtaining one target sub-model; and
obtaining a power amplifier model according to at least one of the target sub-models.

**2.** The method for acquiring a power amplifier model according to claim 1, after each iterative training is completed, further comprising:
updating the labeled data according to the target sub-model, wherein the updated labeled data is used for next iterative training of the sub-model.

**3.** The method for acquiring a power amplifier model according to claim 2, wherein the input data comprises current-time input data and multiple pieces of historical-time input data, and the iteration stop condition is a preset number of iterations; and
the performing iterative training on the initial sub-model comprises:
in response to a current number of iterations being less than the preset number of iterations, inputting the current-time input data and at least one piece of the historical-time input data to the initial sub-model for iterative training.

**4.** The method for acquiring a power amplifier model according to claim 2, wherein the iteration stop condition is that all historical-time input data are used in the iterative training of the model; and
the performing iterative training on the initial sub-model comprises:

generating a priority of each piece of historical-time input data according to a preset priority calculation condition;
constructing a set of historical-time input data according to a current number of times of iterative training of the sub-model and the priorities of the historical-time input data; and
in response to input data of current iterative training not reaching the iteration stop condition, inputting the current-time input data and the set of historical-time input data to the initial sub-model for iterative training.

**5.** The method for acquiring a power amplifier model according to claim 4, wherein the constructing a set of historical-time input data according to a current number of times of iterative training of the sub-model and the priorities of the historical-time input data comprises:

sorting the historical-time input data according to the priorities of the historical-time input data, to obtain sorted historical-time input data; and
sequentially selecting, from the sorted historical-time input data, a target number of historical-time input data to construct the set of historical-time input data, wherein the target number is equal to the current number of times of iterative training of the sub-model.

**6.** The method for acquiring a power amplifier model according to claim 4 or 5, wherein the generating a priority of each piece of historical-time input data according to a preset priority calculation condition comprises:

obtaining an error value of current iterative training of the sub-model;
calculating a correlation between the error value and the historical-time input data; and
obtaining, according to the correlation, the priority of the historical-time input data.

**7.** The method for acquiring a power amplifier model according to claim 4 or 5, wherein the generating a priority of each piece of historical-time input data according to a preset priority calculation condition comprises:

acquiring a pre-trained neural network model;
inputting the historical-time input data to the pre-trained neural network model for fitting, to obtain a fitting accuracy value corresponding to the historical-time input data; and
obtaining, according to the fitting accuracy value, the priority of the historical-time input data.

**8.** The method for acquiring a power amplifier model according to claim 7, wherein the acquiring a pre-trained neural network model comprises:

constructing multiple training data sets through combination based on the current-time input data and at least one piece of the historical-time input data; and
inputting the multiple training data sets to a neural network model separately, and training the neural network model with the labeled data to obtain the pre-trained neural network model.

**9.** The method for acquiring a power amplifier model according to claim 1, wherein the obtaining a power amplifier model according to at least one of the target sub-models comprises:

acquiring a preset statistical dimension and a preset statistical dimension threshold corresponding to the preset statistical dimension;
acquiring a statistical value corresponding to the preset statistical dimension of each of the target sub-models;
determining a target sub-model having a statistical value better than the preset statistical dimension threshold as a power amplifier sub-model; and
determining a model constituted by at least one of the power amplifier sub-models as the power amplifier model.

**10.** The method for acquiring a power amplifier model according to claim 9, wherein the preset statistical dimension is a normalized mean squared error (NMSE), and the preset statistical dimension threshold is an NMSE threshold; and the determining a target sub-model having a statistical value better than the preset statistical dimension threshold as a power amplifier sub-model comprises:

comparing an NMSE of each of the target sub-models to the NMSE threshold; and
using a target sub-model having an NMSE less than or equal to the NMSE threshold as the power amplifier sub-model.

**11.** The method for acquiring a power amplifier model according to claim 9 or 10, wherein the determining a model constituted by at least one of the target sub-models as the power amplifier model comprises:

sorting the power amplifier sub-models according to the statistical values to obtain a sorting order; and
determining a model constituted by the power amplifier sub-models in the sorting order as the power amplifier model.

**12.** An apparatus for acquiring a power amplifier model, comprising:

a memory, a processor, and a computer program stored in the memory and executable by the processor, wherein the processor, when executing the computer program, implements the method for acquiring a power amplifier model of any one of claims 1 to 11.

**13.** A power amplifier model, wherein the power amplifier model is obtained according to the method for acquiring a power amplifier model of any one of claims 1 to 11.

**14.** A computer-readable storage medium storing computer-executable instructions, wherein the computer-executable instructions are configured for implementation of the method for acquiring a power amplifier model of any one of claims 1 to 11.

**15.** A computer program product, comprising a computer program or computer instructions, wherein the computer program or the computer instructions are stored in a computer-readable storage medium, from which a processor of a computer device reads the computer program or the computer instructions, and the computer program or the computer instructions, when executed by the processor, cause the computer device to perform the method for acquiring a power amplifier model of any one of claims 1 to 11.

200
Power amplifier
100
Electronic device
300
Power amplifier model

FIG. 1

Power amplifier
y
x
e
Power amplifier model
ŷ

FIG. 2

S1000
Acquire an initial sub-model, labeled data, and input data of a power amplifier
S2000
Perform, according to the labeled data and the input data, iterative training on the initial sub-model until an iteration stop condition is reached, and after each iterative training is completed, obtain one target sub-model
S3000
Obtain a power amplifier model according to at least one of the target sub-models

FIG. 3

S2110
Obtain an error value of current iterative training of a sub-model
S2120
Calculate a correlation between the error value and historical-time input data
S2130
Obtain, according to the correlation, a priority of the historical-time input data

FIG. 4

S2210
Acquire a pre-trained neural network model
S2220
Input historical-time input data to the pre-trained neural network model for fitting, to obtain a fitting accuracy value corresponding to the historical-time input data
S2230
Obtain, according to the fitting accuracy value, a priority of the historical-time input data

FIG. 5

S2211
Construct multiple training data sets through combination based on current-time input data and at least one piece of historical-time input data
S2212
Input the multiple training data sets to a neural network model separately, and train the neural network model through labeled data to obtain a pre-trained neural network model

FIG. 6

S3100
Acquire a preset statistical dimension and a preset statistical dimension threshold corresponding to the preset statistical dimension
S3200
Acquire a statistical value corresponding to a preset statistical dimension of each of target sub-models
S3300
Determine a target sub-model having a statistical value better than the preset statistical dimension threshold as a power amplifier sub-model
S3400
Determine a target sub-model having a statistical value better than the preset statistical dimension threshold as a power amplifier sub-model

FIG. 7

$X_1$
$NN_1$
$X_2$
$NN_2$
$X_3$
$NN_3$
$X_M$
$NN_M$
Σ
$\hat{y}(n)$

FIG. 8

x(n)
Z-1
Z-1
Z-1
Prioritization
c1
c2
c3
cQ+1
NN1
NN2
NN3
NNM
Σ
ŷ(n)

FIG. 9

x(n)
Z-1
Z-1
Z-1
Z-1
Prioritization
c1
c2
c3
c4
c5
NN1
NN2
NN3
NN4
NN5
Σ
ŷ(n)

FIG. 10

X
X
Unit 1
Unit 2
Unit 3
X
Unit 4
Σ

FIG. 11

Unit 1
$x_1$
$x_2$
$x_N$
|•|
Complex
MLP
network
$z_1$
$z_2$
$z_3$
$z_N$

FIG. 12（a）

Unit 2
$x_1$
$z_1$
$x_2$
$z_2$
$x_N$
$z_N$
Σ

FIG. 12（b）

Unit 3
$\omega_1$
$z_1$
$\omega_2$
$z_2$
$\omega_3$
$z_3$
$\omega_N$
$z_N$
Σ

FIG. 12（c）

Unit 4
$\theta_1$
$\theta_2$
$\theta_3$
$\theta_N$
$x_1$
$x_2$
$x_3$
$x_N$
Σ

FIG. 12（d）

$x(n)$
$Z^{-1}$
Prioritization
$c_1$
$c_2$
$c_3$
$c_4$
$NN_1$
$NN_2$
$NN_3$
$NN_4$
Σ
$\hat{y}(n)$

FIG. 13

x(n)
Z-1
Z-1
Z-1
Z-1
Z-1
Z-1
Z-1
Z-1
Z-1
Prioritization
c1
c2
c3
c4
c5
NN1
NN2
NN3
NN4
NN5
Σ
ŷ(n)

FIG. 14

Apparatus for acquiring a power amplifier model
Memory
1100
Processor
1200

FIG. 15

**INTERNATIONAL SEARCH REPORT**

International application No. **PCT/CN2023/080821**

**A. CLASSIFICATION OF SUBJECT MATTER**

G06F30/367(2020.01)i

According to International Patent Classification (IPC) or to both national classification and IPC

**B. FIELDS SEARCHED**

Minimum documentation searched (classification system followed by classification symbols)

IPC: G06F G06N H03F

Documentation searched other than minimum documentation to the extent that such documents are included in the fields searched

Electronic data base consulted during the international search (name of data base and, where practicable, search terms used)

VEN, CNABS, CNTXT, WOTXT, EPTXT, USTXT, CNKI, IEEE: 功率放大器, 模型, 神经网络, 训练, 输入, 数据, 标签, 迭代, 更新, 当前, 历史, 优先级, 误差, power amplifier, model, neural network, training, input, data, label, iteration, update, current, historical, priority, error

**C. DOCUMENTS CONSIDERED TO BE RELEVANT**

| Category* | Citation of document, with indication, where appropriate, of the relevant passages | Relevant to claim No. |
|---|---|---|
| X | CN 113762503 A (TENCENT CLOUD COMPUTING (BEIJING) CO., LTD.) 07 December 2021 (2021-12-07)<br>description, paragraphs [0003]-[0015], and abstract | 1-3, 12-15 |
| A | CN 105224985 A (NANJING UNIVERSITY OF AERONAUTICS AND ASTRONAUTICS) 06 January 2016 (2016-01-06)<br>entire document | 1-15 |
| A | CN 111092602 A (COMBA TELECOM SYSTEMS (CHINA) CO., LTD.) 01 May 2020 (2020-05-01)<br>entire document | 1-15 |
| A | US 2019238101 A1 (SKYWORKS SOLUTIONS, INC.) 01 August 2019 (2019-08-01)<br>entire document | 1-15 |
| A | US 2022200540 A1 (ULAK HABERLESME A.S.) 23 June 2022 (2022-06-23)<br>entire document | 1-15 |

☐ Further documents are listed in the continuation of Box C.  ☑ See patent family annex.

* Special categories of cited documents:
- "A" document defining the general state of the art which is not considered to be of particular relevance
- "D" document cited by the applicant in the international application
- "E" earlier application or patent but published on or after the international filing date
- "L" document which may throw doubts on priority claim(s) or which is cited to establish the publication date of another citation or other special reason (as specified)
- "O" document referring to an oral disclosure, use, exhibition or other means
- "P" document published prior to the international filing date but later than the priority date claimed
- "T" later document published after the international filing date or priority date and not in conflict with the application but cited to understand the principle or theory underlying the invention
- "X" document of particular relevance; the claimed invention cannot be considered novel or cannot be considered to involve an inventive step when the document is taken alone
- "Y" document of particular relevance; the claimed invention cannot be considered to involve an inventive step when the document is combined with one or more other such documents, such combination being obvious to a person skilled in the art
- "&" document member of the same patent family

| Date of the actual completion of the international search | Date of mailing of the international search report |
|---|---|
| **08 June 2023** | **13 June 2023** |

| Name and mailing address of the ISA/CN | Authorized officer |
|---|---|
| **China National Intellectual Property Administration (ISA/CN)**<br>**China No. 6, Xitucheng Road, Jimenqiao, Haidian District, Beijing 100088** | <br>Telephone No. |

Form PCT/ISA/210 (second sheet) (July 2022)

**INTERNATIONAL SEARCH REPORT**
**Information on patent family members**

International application No.
**PCT/CN2023/080821**

| Patent document cited in search report | | | Publication date (day/month/year) | Patent family member(s) | | | Publication date (day/month/year) |
|---|---|---|---|---|---|---|---|
| CN | 113762503 | A | 07 December 2021 | WO | 2022246986 | A1 | 01 December 2022 |
| CN | 105224985 | A | 06 January 2016 | | None | | |
| CN | 111092602 | A | 01 May 2020 | | None | | |
| US | 2019238101 | A1 | 01 August 2019 | US | 2021184636 | A1 | 17 June 2021 |
| | | | | US | 2022321063 | A1 | 06 October 2022 |
| US | 2022200540 | A1 | 23 June 2022 | | None | | |

Form PCT/ISA/210 (patent family annex) (July 2022)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- CN 202210885045